# DEMANDE DE BREVET EUROPEEN

(11) **EP 4 439 682 A1**
(43) Date de publication de la demande: **02.10.2024**
(21) Numéro de dépôt: 24157206.4
(22) Date de dépôt: 12.02.2024
(51) Int. Cl.: H01L 31/109, H01L 31/032, H01L 29/24

(54) **(AL)GA2O3/(MG)NIO HÉTÉROJONCTIONS TERNAIRES POUR LES APPLICATIONS ÉLECTRONIQUES ET OPTOÉLECTRONIQUES**

(30) Priorité: 12.02.2023 FR 2301291
(71) Demandeur: Rogers, David J., 10300 Sainte Savine (FR); Hosseini-Teherani, Ferechteh, 91400 Orsay (FR); Sandana, Vinod E., 95140 Garges les Gonesse (FR); Bove, Philippe H., 91190 Gif sur Yvette (FR)
(72) Inventeur: Rogers, David J., 10300 Sainte Savine (FR); Hosseini-Teherani, Ferechteh, 91400 Orsay (FR); Sandana, Vinod E., 95140 Garges les Gonesse (FR); Bove, Philippe H., 91190 Gif sur Yvette (FR)
(74) Mandataire: Setayesh Bamas, Sousan

(57) **Abrégé**

Diode bipolaire ou PIN à hétérojonction verticale à base d'hétérostructures entre les alliages ternaires (Mg)NiO et (AI)Ga2O3 ou (Mg)NiO/i-MgO/(AI)Ga2O3 ou (Mg)NiO/Al2O3/(Al)Ga2O3) caractérisée en ce que le (Mg)NiO étant de type p, le (Al)Ga₂O₃ étant de type n et la couche intrinsèque soit en MgO ou AI2O3, et que les bandes interdites de Ga2O3 et de NiO ont été augmentées par des alliages avec AI et/ou Mg afin de concevoir de manière appropriée l'alignement desdites bandes interdites et d'optimiser l'injection de porteurs pour permettre le fonctionnement plus efficace de la diode, l'opération d'un photodétecteur à des longueurs d'onde plus courtes et l'opération de l'électronique de puissance à des tensions plus élevées.

## Description

### Domaine technique

Cette invention propose de nouvelles diodes à hétérojonction (Mg)NiO/(AI)Ga2O3 p-n à utiliser dans l'électronique haute puissance et les photodétecteurs UVC, ainsi qu'un procédé pour les fabriquer. La nature inventive est liée à la fois au nouveau concept d'exploitation du potentiel semi-conducteur de ces matériaux d'oxydes et à la méthode innovante pour les fabriquer.

Environ la moitié de l'énergie consommée dans le monde est sous forme de l'électricité [1] et plus de 30 % de notre approvisionnement en électricité passe par des composants d'électronique de puissance (PE) [2]. La grande majorité des composants électroniques utilisée actuellement sont à base de silicium. Ceux-ci, cependant, sont limités en puissance et ont des «résistances passantes» élevées pour le fonctionnement HT (haute tension), et donc des pertes irréversibles très importantes. Pour lutter contre ces problèmes, une deuxième génération d'électronique de puissance (PE) basée sur des semi-conducteurs à large bande interdite (WBG) tels que SiC et GaN a été développée au cours des dernières décennies. Cependant, les substrats et/ou les couches actives des deux matériaux sont produits par des techniques gourmandes en énergie et sont encore très onéreux [3].

Par ailleurs, les photodétecteurs (PD) ultraviolets (UV) font leur apparition pour des applications telles que la détection de flammes/étincelles, la détection d'agents chimiques/biologiques, les contre-mesures militaires, la surveillance environnementale, la surveillance de la stérilisation, la détection sans ligne de mire, communications et astronomie spatiale UV [1-4]. Pour minimiser les fausses alarmes et l'encombrement en arrière-plan, bon nombre de ces appareils fonctionnent dans la partie UVC du spectre solaire (SB) inférieur à 290 nm (<290 nm). La plupart des photodétecteurs (PD) actuels utilisent des photomultiplicateurs (PM). Ceux-ci sont basés sur des tubes à vide, qui sont volumineux, fragiles (mécaniquement et électriquement), coûteux et nécessitent des tensions de fonctionnement élevées. Les photodétecteurs PD dits "Solar Blind" ou aveugle au soleil à semi-conducteurs, basés sur des transitions quantiques dans les semi-conducteurs, sont beaucoup plus robustes que les photo-multiplicateurs PM et promettent à la fois des avantages en termes de taille et de coût par rapport aux photo-multiplicateurs (PM). Ils ont également le potentiel d'une efficacité quantique plus élevée, d'une sélectivité intrinsèque de la gamme spectrale, de durées de vie prolongées, d'un bruit plus faible et de besoins en puissance plus faibles.

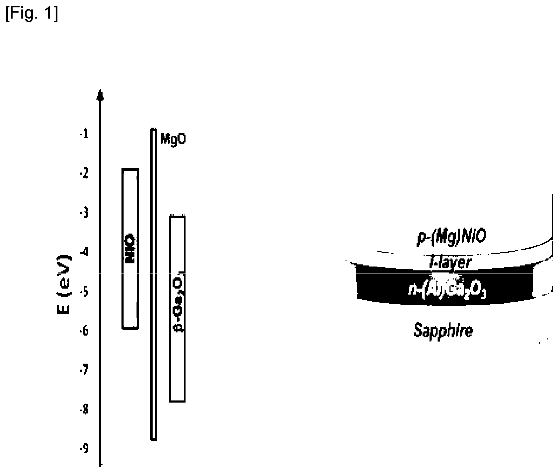

Les photodiodes au silicium sont utilisées depuis longtemps pour la détection UV. Bien qu'elles fonctionnent bien, leur bande interdite est relativement faible, elles répondent donc aussi bien au spectre visible qu'aux signaux UV et nécessitent des filtres optiques pour être soit visibles, soit aveugles au soleil. Cependant, une classe de matériaux appelés semi-conducteurs à «large bande interdite (WBG)» sont naturellement visibles au spectre solaire. La figure 1 met en contraste la plage de fonctionnement de la longueur d'onde qui peut être atteinte pour les optosemiconducteurs WBG courants. Le carbure de silicium (SiC), avec une bande interdite à température ambiante de 2,4 à 3,1 eV, a été le premier semi-conducteur WBG à être adopté commercialement comme PD UVC (par exemple dans les détecteurs de flamme) [5]. Cependant, la bande interdite du SiC n'est pas suffisamment élevée pour qu'il soit intrinsèquement invisible au spectre solaire SB, et l'ingénierie de la bande interdite par alliage n'est pas possible. Ainsi, l'insertion de filtres optiques est toujours nécessaire afin d'accorder la photo détection à la gamme UVC. Le nitrure de gallium (GaN), d'autre part, a une bande interdite qui est réglable de la plage UV proche à lointaine grâce à l'alliage avec de l'aluminium, et les dispositifs à base de (AI) GaN ont été largement explorés pour la détection de la lumière UV directement dans la gamme SB [6-8]. Cependant, ce système de matériaux souffre de plusieurs problèmes clés : de grandes densités de dislocations, une faible conductivité et des discordances réseau/expansion thermique (avec le substrat en saphir conventionnel) qui conduisent à la fissuration et à la baisse d'efficacité avec l'augmentation de la teneur en Al. Le résultat est qu'il y a eu un succès limité dans la démonstration de PD aveugles au soleil (Solar Blind Photo Detector ou SBPD) à base de (AI)GaN avec à la fois de faibles signaux de fond et de bons rendements quantiques pour des longueurs d'onde inférieures à 250 nm [9,10]. (Mg)ZnO est basé sur la wurtzite ZnO, qui a une large bande interdite directe de ~ 3,4 eV qui peut être réglée dans la gamme spectre solaire SB en s'alliant avec MgO (par exemple ~ 7,8 eV) [11]. L'ion Mg a un rayon similaire à celui de Zn [12], il y a donc moins de problèmes de perte de contrainte et d'efficacité que pour (AI)GaN. Cependant, à mesure que la teneur en Mg augmente, la phase hexagonal et compactée ou "close packed", (hcp)ZnO se transforme en phase cubique face centrée (fcc) MgO qui est de nature beaucoup plus isolante et moins adaptée aux applications dans des dispositifs. Ainsi, le fonctionnement spectre solaire, SB est limité à une plage supérieure à environ 250 nm.

Bien que le nitrure de bore (BN) et le diamant (D) aient des «bandes interdites ultra-larges» (UWBG) intrinsèques (de 6,1 et 5,5 eV, respectivement) qui sont très attrayantes pour le fonctionnement SB [13,14], ils sont difficiles à développer sous forme de film mince à grande surface avec une haute qualité cristalline et de faibles densités de défauts. Quant au SiC, ils ont également tous une portée limitée pour l'ingénierie de la bande interdite plus loin dans l'UV. Par conséquent, il existe un besoin pour un système semi-conducteur plus approprié pour la détection sélective en longueur d'onde dans la plage UVC de 200 à 250 nm.

### Technique antérieure

Récemment, une troisième génération très prometteuse d'électronique de puissance PE et de photodetecteur,PD basée sur le WBG Ga2O3 (Eg = 4,9 eV, qui peut être amélioré par addition d'AI [4]), est apparue [5]. Cela résulte de la découverte de la dopabilité de type n dans le matériau Ga2O3 qui était auparavant considéré comme un isolant. Par conséquent, il y a eu une augmentation de la recherche & du développement (R&D) axée sur l'électronique de puissance de communication/amplification à base de β -Ga2O3 et la photodétection UVC [6] (principalement aux États-Unis, en Asie et en Allemagne). L'application électronique de puissance, PE est également fondée sur le potentiel d'une résistance à l'état passant beaucoup plus faible accompagnée d'un claquage (~8MV/cm) et d'un facteur de mérite de Baliga (-1 GW/cm2) qui dépasse largement ceux de Si, GaN ou SiC [5]. De nombreuses techniques standard de croissance de couches minces ont été adoptées pour la fabrication de dispositifs à base de Ga2O3 (par exemple MBE, ALD, MOCVD, HVPE) [13], [14] &NiO [15]. Étant donné que les dopants peu profonds de type p ne sont pas disponibles ou très peu efficace à ce jour pour Ga2O3 [7], les dispositifs bipolaires à homojonction Ga2O3 ne sont cependant pas possibles. En effet, utilisation d'architectures de jonction p-n, telles que celles utilisées dans les dispositifs à base de GaN.

Pour l'électronique de puissance, il s'agit d'un facteur clé limitant le potentiel de réduction de la résistance à l'état passant tout en maintenant le champ de claquage (Vbr) élevé. Ainsi, la capacité de dopage de type p est de la plus haute importance dans la quête de performances ultimes.

De même, l'éventail des possibilités avec les capteurs UVC à base de Ga2O3 est également limité par le manque de disponibilité de l'homojonction p-n. Par exemple, ils sont limités dans leur autonomie car ils nécessitent une tension de polarisation pour fonctionner, ce qui n'est pas le cas des dispositifs à base de jonction p-n fonctionnant en mode photovoltaïque.

Cependant, il est généralement admis que des niveaux utiles de dopage accepteur superficiel majoritaire (type p) dans le β-Ga2O3 sont peu susceptibles d'être obtenus en raison d'une combinaison de facteurs, notamment le niveau d'énergie absolue relativement faible de la bande de valence, l'absence d'un accepteur peu profond identifié, les masses effectives relativement élevées de trous au sommet de la bande de valence, la propension à l'auto-piégeage des trous et l'énergie de formation relativement faible du donneur de fond d'oxygène (qui compensent les accepteurs ) [139, 148, 195]. Il existe néanmoins plusieurs rapports évoquant des couches relativement résistives à dopage de type p prédominant en β-Ga2O3 nominalement non dopé [196, 197], dopé H [198] et dopé N [199]. Dans ce dernier cas, des MOSFET latéraux β -Ga2O3 de type p ont été signalés. L'absence d'une couche de type p à faible résistance pour l'anode a, jusqu'à présent, empêché la démonstration d'une diode à homojonction p-n β-Ga2O3, mais des diodes à hétérojonction p-n ont été réalisées en intégrant du Ga2O3 de type n avec des semi-conducteurs de type p tels que Cu2O [200] et NiO [201-204]. Avec une bande interdite de 3,7 eV, NiO est l'oxyde de type p complémentaire de choix grâce à sa robustesse et sa dopabilité flexible [9].

L'état de l'art dans la littérature utilise des semi-conducteurs binaires (par exemple n-Ga2O3 et p-NiO) pour former l'hétérojonction.

### Résumé de l'invention

Cette invention propose des hétérojonctions de nouveaux matériaux semi-conducteurs ternaires à large bande interdite/hétérojonctions (AI)Ga2O3/(Mg)NiO. L'alliage avec Al et Mg [8], respectivement, est introduit afin d'ajuster les bandes interdites Ga2O3 et NiO. Cela montre que (i) ces composés ternaires ont un ensemble de propriétés beaucoup plus grand et plus accordable que les binaires (ii) l'électronique de puissance est une quête de matériaux à bande interdite plus élevée plus robustes/accordables.

L'invention propose une diode bipolaire ou PIN à hétérojonction verticale à base d'hétérostructures entre les alliages ternaires (Mg)NiO et (AI)Ga2O3 ou (Mg)NiO/i-MgO/(AI)Ga2O3 ou (Mg)NiO/AI2O3/(AI)Ga2O3). La diode est caractérisée en ce que le (Mg)NiO étant de type p, le (Al)Ga₂O₃ étant de type n et la couche intrinsèque étant en MgO ou en Al2O3. les bandes interdites de Ga2O3 et de NiO ont été augmentées par des alliages avec Al et Mg respectivement afin de concevoir de manière appropriée l'alignement desdites bandes interdites et d'optimiser l'injection de porteurs pour permettre le fonctionnement plus efficace de la diode bipolaire, ou de l' opération d'un photodétecteur à des longueurs d'onde plus courtes, ou de I 'opération de l'électronique de puissance à des tensions plus élevées.

Selon des caractéristiques particulières, dans la diode bipolaire ou PIN à hétérojonction verticale à base d'héterostructures (Mg)NiO/(AI)Ga2O3 ou (Mg)NiO/i-MgO/(AI)Ga2O3 ou (Mg)NiO/AI2O3/(AI)Ga2O3, le n-AIGa2O3 étant dopé en impuretés peu profondes, en utilisant Si ou Sn et p-MgNiO étant dopé en impuretés peu profonde en utilisant Li de manière à concevoir la concentration de porteurs et le niveau de Fermi pour un alignement de bande interdite et une injection de porteurs plus efficace et améliorée.

Selon des caractéristiques particulières, dans la diode bipolaire ou PIN à hétérojonction verticale à base d'hétérostructures (Mg)NiO/(AI)Ga2O3 ou (Mg)NiO/i-MgO/(AI)Ga2O3 ou (Mg)NiO/i-AI2O3/(AI)Ga2O3, la croissance sur mesure et contrôlée des couches continues de MgO 2D avec i-dopage permet de gérer le champs électrique interne.

Selon des caractéristiques particulières, dans la diode bipolaire ou PIN à hétérojonction verticale à base d'hétérostructures (Mg)NiO/MgO/(AI)Ga2O3 ou (Mg)NiO/i-MgO/(AI)Ga2O3 ou (Mg)NiO/AI2O3/(AI)Ga2O3, la croissance de (AI)Ga2O3 de type n, (Mg)NiO de type p et MgO et Al2O3 intrinsèques I est effectuée par épitaxie à savoir : épitaxie par jets moléculaires(MBE) ou épitaxie de couche atomique (ALD) ou épitaxie en phase vapeur aux organométalliques (MOCVD) ou épitaxie en phase vapeur aux hydrures (HVPE) ou dépôt par pulvérisation cathodique (diode et rf) ou par dépôt par ablation laser(PLD) ou par déposition par faisceau d'électrons (ou ions).

Selon des caractéristiques particulières, dans la diode bipolaire ou PIN à hétérojonction verticale à base d'hétérostructures (Mg)NiO/(AI)Ga2O3 (ou (Mg)NiO/i-MgO/(AI)Ga2O3 ou (Mg)NiO/AI2O3/(AI)Ga2O3, la croissance adaptée et contrôlée de dopage de type n de(AI)Ga2O3, et de dopage de type p de (Mg)NiO est sur une plage de 10¹⁴à 10²⁰ /cm⁻³afin d'optimiser la performance du composant et permettre la gestion du champ électrique interne.

Selon des caractéristiques particulières, dans la diode bipolaire ou PIN à hétérojonction verticale à base d'héterostructures (Mg)NiO/(AI)Ga2O3 ou (Mg)NiO/i-MgO/(AI)Ga2O3 ou (Mg)NiO/AI2O3/(AI)Ga2O3, les propriétés électriques pouvant être ajustées par un contrôle de dopage in situ, via la stoechiométrie d'oxygène et/ou par le dopage Sn, Si, Li et/ou par des post-traitements par irradiation et/ou thermique.

Selon des caractéristiques particulières, dans la diode bipolaire ou PIN à hétérojonction verticale à base d'hétérostructures (Mg)NiO/(AI)Ga2O3 ou (Mg)NiO/i-MgO/(AI)Ga2O3 ou (Mg)NiO/AI2O3/(AI)Ga2O3, les propriétés de chaque couche et des interfaces entre les couches à savoir la structure cristalline, la composition, l'épaisseur, la conductivité, la mobilité, l' alignement des bandes et le niveau de dopage sont conçues de sorte à donner un comportement d'hétérojonction P-N adapté à l'électronique de puissance, ou à la photodétection UVC.

### Brève description des dessins

[Fig.1] Hétérojonctions PN & PIN à base d'hétérostructures (Mg)NiO(type P) / MgO (I) /(AI) Ga2O3 (type N).

Fig.1 illustre un alignement des bandes et schéma d'une jonction p-i-n formée à l'aide de (AI)Ga2O3 dopé n et de (Mg)NiO dopé p et d'une couche intermédiaire MgO intrinsèque.

La nature des porteurs minoritaires de ces dispositifs devrait permettre des résistances à l'état passant plus faibles et par conséquent, offrir de meilleures performances à l'état passant et une gamme de fonctionnalités améliorée. L'architecture verticale apportera également des réductions de l'encombrement actuel et une empreinte plus petite (ce qui augmente directement la densité d'intégration des circuits et réduit le coût par appareil).

### Description des modes de réalisation

L'invention propose de nouvelles diodes bipolaires p-(Mg)NiO/n-(Al)Ga2O3 verticales. L'alliage avec Al et Mg est introduit afin d'ajuster les bandes interdites déjà ultra WBG de Ga2O3 et NiO, améliore la capacité à fonctionner davantage dans les UV et en mode photovoltaïque auto-alimenté. Pour les circuits de puissance, les bandes interdites accrues augmentent la capacité de gestion de la puissance et améliorent l'aptitude à une utilisation dans des environnements difficiles.

En effet, des couches minces de (AI)Ga2O3 dopé n et de (Mg)NiO dopé p peuvent former des jonctions p-n et, avec l'insertion d'intercouches intrinsèques (par exemple MgO), peuvent former des jonctions p-i-n. Les propriétés électriques peuvent être ajustées par un contrôle de dopage in situ (par stoechiométrie d'oxygène et/ou dopage Sn, Si, Li) et/ou des post-traitements par irradiation. Les bandes interdites seront conçues par alliage Al & Mg, respectivement.

Cette invention propose la première hétérojonction p-n des deux oxydes semi-conducteurs UWBG(AI)Ga2O3 dopé n et (Mg)NiO dopé p avec un alignement de bande et des niveaux de dopage modifiés. L'alliage et l'ajout d'impuretés dopantes ajoutent des défis car ils ont un impact sur la structure cristalline et les morphologies de surface/interface, via la diffusion externe des impuretés, les effets de ségrégation, la diffusion de surface et les considérations d'énergie de surface, qui jouent tous un rôle actif pendant la croissance. D'autres aspects innovants sont liés à : (a) une meilleure compréhension et maîtrise de l'ingénierie des contraintes dans (et entre) les couches (AI)Ga2O3 et (Mg)NiO, (b) l'établissement d'interfaces abruptes pour un fonctionnement optimal du dispositif, (c) le développement et la maîtrise technologies de modulation du transport des porteurs basées sur la modélisation, le dopage/alliage in-situ et l'irradiation ex-situ et le(s) post-traitement(s).

La croissance épitaxiale de 'i-MgO' nécessite une croissance continue, sans trou d'épingle et extrêmement mince, plusieurs nanomètres au maximum. Cette couche devra, de plus être électriquement isolante.

### MEILLEUR MODE DE RÉALISATION DE L'INVENTION

Fabrication de (AI)Ga2O/(Mg)NiO et (AI)Ga2O/MgO/(Mg)NiO épitaxiés avec des propriétés de couche et d'interface étant adaptées de manière appropriée. Le dispositif nécessite une qualité cristalline élevée, des interfaces nettes et des propriétés électriques adaptées aux cibles (y compris l'obtention reproductible de niveaux de porteurs très faibles). Un dopage contrôlé de type n, de type p et intrinsèques de ces matériaux est nécessaire afin d'obtenir des matériaux fonctionnels adaptés aux applications de dispositifs d'électronique de puissance, PE.

Le principal défi est d'aborder les propriétés d'interface pour une composition de bande interdite spécifique tout en ciblant des niveaux de dopage/d'activation et des caractéristiques électriques « optimaux ».

Croissance d'épicouches de (AI)Ga2O3, MgO et (Mg)NiO avec des bandes interdites contrôlées, une qualité cristalline élevée, des morphologies de surface lisses et de très faibles densités de porteurs sans fond.

Le n-AIGa2O3 et le p-MgNiO seront dopés en impuretés peu profondes en utilisant par exemple Si [16], Sn [6] et Li [9,15] respectivement afin de modifier la concentration de porteurs et le niveau de Fermi pour un alignement de bande et une injection de porteuse appropriés. Les propriétés de la couche et de l'interface (structure cristalline, composition, épaisseur, conductivité, mobilité, alignement des bandes et niveaux/gradients de dopage) sont conçues de manière à donner un comportement d'hétérojonction p-n adapté aux applications ciblées [25][26].

Un autre défi majeur est la gestion des contraintes et l'alignement des bandes à l'interface en raison des effets surface/interface ; c'est-à-dire la réorganisation atomique locale (qui devrait être importante en raison des différentes structures cristallines et des désadaptations du réseau importantes entre deux familles de matériaux) et les effets de transfert de charge correspondants. L'inadéquation du réseau ainsi que la présence de concentrations d'impuretés relativement élevées (par exemple Al dans Ga2O3 et Mg dans NiO) peuvent également conduire à la formation d'états d'interface localisés qui peuvent avoir un impact, par exemple. sur la conductivité électrique pour une configuration de jonction p-i-n.

Le contrôle du dopage n (AI)Ga2O3 (sur une plage de 10¹⁴ à 10¹⁹ cm⁻³) est nécessaire pour la gestion du champ électrique interne. Le contrôle du dopage p NiO (sur la plage de 10¹⁴ - 10¹⁹ cm⁻³) est nécessaire pour la gestion du champ électrique interne. Il est également possible de réaliser un dopage MgNiO et AIGaO par irradiation ou implantation.

### Liste des documents cités

[1] S. Reese, et al. "Combien coûtera l'électronique de p uissance à l'oxyde de gallium ?", Joule 3(4), 903-907 (2019)
[2] L.M. Tolbert, et al., "Électronique de puissance pour les systèmes d'énergie distribuée et les applications de transmission et de distribution : évaluation des besoins techniques pour les applications de services publics." (Oak Ridge, TN : Laboratoire national d'Oak Ridge, 2005)
[3] B. Reese et al. "Analyse technico-économique du Ga2O3 pour le marché des semi-conducteurs WBG", Proc. SPIE 11281OH (2020)
[4] F.Zhang et al. Ingénierie à large bande interdite des films AlGa2O3 Appl. Phys. Lett. 105, 162107 (2014)
[5] Pérez, Rogers et al. Oxydes WBG : quand le PV rencontre l'électronique de puissance transparente Proc SPIE 10533 (2018) 1Q1
[6] Higashiwaki et al. « MESFET Ga2O3 sur substrats monocristallins β -Ga2O3 (010) » Appl. Phys. Lett. 100, 013504 (2012)
[7] M. Tadjer et al Théorie et caractérisation du dopage et des défauts dans Ga2O3 ECS J. Solid State Sci Tech. 8 Q3187 (2019)
[8] C. A. Niedermeier et al.Band gap bowing in NixMg1-xO Scientific Reports 6(1):31230 (2016)
[9] S. Lany et al. Asymétrie de dopage dans les oxydes : dopage des trous NiO vs dopage électronique ZnO Phys. Rév. B 75, 241203R (2007)
[10] Higashiwaki et al. FET Ga2O3 en mode appauvrissement sur la dépendance β-Ga2O3 & T Appl. Phys. Lett. 103, 123511 (2013)
[11] Z. Cheng et al. Intégration de Ga2O3 sur Diamant pour la Gestion thermique, Appl. Phys. Lett. 116, 062105 (2020)
[12] Rogers et al. Décollage chimique et laser pour le transfert de GaN vers des substrats alternatifs Proc. SPIE 8626 (2013) 11-1
[13] Razeghi, Rogers et al Review of Growth, Doping & Applications of Ga2O3 thin films" Proc of SPIE 10533 (2018) 0R1
[14] Rogers et al Sélectivité UVC réglable et cécité solaire dans les photodétecteurs PLD Ga2O3 Proc SPIE 11687 (2021) 201
[15] Sandana, Rogers et al. FET à couches minces de type p basés sur des canaux NiO: Li de PLD Proc. SPIE 10919 (2019) 1H-1
[16] Sasaki Si-Ion Implantation Doping in Ga2O3 & Fabrication of Low-Resistance Ohmic Contacts Appl Phys Express 6 086502 (2013)
[17] Y.Lv et al. Démonstration de diodes Schottky à barrière de jonction Ga2O3 avec une figure de mérite de Baliga de 0,85 GW/cm2 ou des capacités de gestion de 5 A/700 V, IEEE Trans. Électron de puissance. 36, 6179 (2021)
[18] Yao, Davis, Robert & Porter, Enquête sur différents métaux en tant que contacts ohmiques avec β-Ga2O3 : comparaison et analyse du comportement électrique, de la morphologie et d'autres propriétés physiques. Journal des matériaux électroniques . 46. 10.1007/s 11664-016-5121-1.
[19] Abou Daher et al HEMT AIGaN/GaN sur diamant par liaison AIN J Vac SciTechnol B 38 3 (2020) 033201
[20] X. Gonze et al, Computer Phys. Commun. 180, 2582-2615 (2009)
[21] http://www.bethe-salpeter.org
[22] M.L. Trolle, et al. , Sci. Rep. 7, 39844; doi : 10.1038/srep39844 (2017)
[23] Chikoidze Rogers et al Une conductivité 2D robuste et déconcertante dans des films de Ga2O3 non dopés Mat TodayPhysics 8 (2019)
[24] Sandana, Rogers et al Étude des hétérojonctions transparentes p-NiO/n-ZnO par PLD Proc SPIE 9364 (2015) 1O-1
[25] FH Teherani, D.J. Rogers, et al., "Une étude sur l'impact de l'orientation du substrat de saphir sur les propriétés des couches minces de β-Ga2O3 nominalement non dopées cultivées par dépôt laser pulsé". Proc. de SPIE 10105,101051R-1 (2017)
[26] V.E. Sandana et al. Croissance de NiO sur Si (111), c-Al2O3 & FTO/Verre par PLD, Proc. de SPIE 8987, 89872P-1 (2014)
[27] T.- Dang et al., Effect of high-energyelectron irradiation on Ga2O3 electronic properties, Proc SPIE 1200207 (2022) [28] De france, Fabrication/Caractérisation/Analyse des HEMT AIGaN/GaN sur les substrats flexibles IEEE Trans Elec Dev 60 3 2013
[29] Kubsky et al. "Analyse de la composition locale des microstructures de SiC formées par projection d'ions dans du Si à l'aide d'un TEM filtré par énergie en combinaison avec la préparation d'échantillons FIB" J. Mat. Sci. Ing. B, Vol 102, I 1-3, 2003, p. 70-74
[30] Scheiderer et al. Matériaux pour Mottronics : Dopage O excessif de l'isolant Mott prototypique Adv. Tapis. 30 1706708 201 8

## Revendications

1. Diode bipolaire ou PIN à hétérojonction verticale à base d' hétérostructures entre les alliages ternaires (Mg)NiO et (AI)Ga2O3 ou (Mg)NiO/i-MgO/(AI)Ga2O3 ou (Mg)NiO/Al2O3/(Al)Ga2O3) **caractérisée en ce que** le (Mg)NiO étant de type p, le (Al)Ga₂O₃ étant de type n et la couche intrinsèque soit en MgO ou Al2O3, et que les bandes interdites de Ga2O3 et de NiO ont été augmentées par des alliages avec Al et/ou Mg afin de concevoir de manière appropriée l'alignement desdites bandes interdites et d'optimiser l'injection de porteurs pour permettre le fonctionnement plus efficace de la diode, l'opération d'un photodétecteur à des longueurs d'onde plus courtes et l' opération de l'électronique de puissance à des tensions plus élevées.

2. Diode bipolaire ou PIN à hétérojonction verticale à base d' hétérostructures (Mg)NiO/(AI)Ga2O3 ou (Mg)NiO/i-MgO/(AI)Ga2O3 ou (Mg)NiO/AI2O3/(AI)Ga2O3 selon la revendication 1 dans laquelle n-AIGa2O3 étant dopé en impuretés peu profondes, en utilisant Si ou Sn et p-MgNiO étant dopé en impuretés peu profonde en utilisant Li de manière à concevoir la concentration de porteurs et le niveau de Fermi pour un alignement de bande interdite et une injection de porteurs plus efficace et améliorée.

3. Diode bipolaire ou PIN à hétérojonction verticale à base d' hétérostructures (Mg)NiO/(AI)Ga2O3 ou (Mg)NiO/i-MgO/(AI)Ga2O3 ou (Mg)NiO/i-AI2O3/(AI)Ga2O3 selon la revendication 1 ou 2 dans laquelle, une croissance sur mesure et contrôlée des couches continues de MgO 2D avec i-dopage permet de gérer le champs électrique interne.

4. Diode bipolaire ou PIN à hétérojonction verticale à base d' hétérostructures (Mg)NiO/MgO/(AI)Ga2O3 ou (Mg)NiO/i-MgO/(AI)Ga2O3 ou (Mg)NiO/AI2O3/(AI)Ga2O3selon la revendication 1 ou 2 ou 3, dans laquelle, la croissance de (AI)Ga2O3 de type n, (Mg)NiO de type p et MgO et Al2O3 intrinsèques est effectuée par épitaxie à savoir : épitaxie par jets moléculaires, (MBE) ou épitaxie de couche atomique, (ALD) ou épitaxie en phase vapeur aux organométalliques (MOCVD) ou épitaxie en phase vapeur aux hydrures (HVPE) ou dépôt par pulvérisation cathodique (diode et rf) ou par dépôt par ablation laser(PLD) ou par déposition par faisceau d'électrons (ou ions).

5. Diode bipolaire ou PIN à hétérojonction verticale à base d' hétérostructures (Mg)NiO/(AI)Ga2O3 (ou (Mg)NiO/i-MgO/(AI)Ga2O3 ou (Mg)NiO/AI2O3/(AI)Ga2O3 selon l'une des revendications 1 à 4 dans laquelle la croissance adaptée et contrôlée de dopage de type n de(AI)Ga2O3, et de dopage de type p de (Mg)NiO est sur une plage de 10¹⁴à 10²⁰ /cm⁻³ afin d' optimiser la performance du composant et pouvant permettre la gestion du champ électrique interne.

6. Diode bipolaire ou PIN à hétérojonction verticale à base d' hétérostructures (Mg)NiO/(AI)Ga2O3 ou (Mg)NiO/i-MgO/(AI)Ga2O3 ou (Mg)NiO/AI2O3/(AI)Ga2O3 selon l'une des revendications 1à 5 dont des propriétés électriques pouvant être ajustées par un contrôle de dopage in situ, par un contrôle de la proportion d'oxygène et/ou par un dopage Sn, Si, Li et/ou par des post-traitements par irradiation et/ou thermique, de sorte à obtenir une concentration et un niveau de Fermi pour un alignement de bande interdite et une injection de porteurs plus efficace et améliorée.

7. Diode bipolaire ou PIN à hétérojonction verticale à base d' hétérostructures (Mg)NiO/(AI)Ga2O3 ou (Mg)NiO/i-MgO/(AI)Ga2O3 ou (Mg)NiO/AI2O3/(AI)Ga2O3 selon l'une des revendications 1 à 6 utilisée dans l' électronique de puissance ou dans la photodétection UVC.
